Europäisches Patentamt

European Patent Office

Office européen des brevets

(19)

(11) Publication number: **0 303 521**
**A2**

# (12) EUROPEAN PATENT APPLICATION

(21) Application number: **88307561.6**

(22) Date of filing: **15.08.88**

(51) Int. Cl.⁴: **H 01 L 39/24**

(30) Priority: **13.08.87 JP 202142/87**
**13.08.87 JP 202143/87**
**13.08.87 JP 202144/87**
**13.08.87 JP 202145/87**

(43) Date of publication of application:
**15.02.89 Bulletin 89/07**

(84) Designated Contracting States: **DE FR GB**

(71) Applicant: **SEMICONDUCTOR ENERGY LABORATORY CO., LTD.**
**398 Hase**
**Atsugi-shi Kanagawa-ken, 243 (JP)**

(72) Inventor: **Yamazaki, Shunpei**
**21-21 Kitakarasuyama 7-chome**
**Setagaya-Ku Tokyo (JP)**

(74) Representative: **Milhench, Howard Leslie et al**
**R.G.C. Jenkins & Co. 26 Caxton Street**
**London SW1H 0RJ (GB)**

(54) Superconducting device and methods of manufacturing the same.

(57) An improved electronic device utilizing a superconducting material is disclosed. In order to avoid undesirable oxidation during firing of a superconducting ceramic material formed on a semiconductor device substrate, the superconducting material is provided only where the superconducting material does not contact an operational region of the semiconductor substrate.

EP 0 303 521 A2

**Description**

## SUPERCONDUCTING DEVICES AND METHODS OF MANUFACTURING THE SAME

### BACKGROUND OF THE INVENTION

This invention relates to superconducting devices and methods of manufacturing the same.

In addition to the requirement for more densely packed integrated circuits, there is also a requirement for high operational speeds. However, the fine structures required for obtaining more densely packed electric circuits can give rise to problems of decreased operational speeds and reduced reliability at exothermic parts of integrated circuits. Because of this, if semiconductor devices are driven at liquid nitrogen temperatures, the mobilities of electrons and holes become 3 to 4 times faster than those at room temperature and as a result the frequency characteristics can be improved.

A proposal for making use of superconductors in semiconductor devices is described in our Japanese Patent Application No. Sho 62-053724 filed on March 9th, 1987. In that application, it is proposed that lead lines might be made of superconducting ceramic materials. The superconducting ceramics have to be fired for a long time period in an oxidizing atmosphere after they have been applied on to the semiconductor substrate in the required location, and because of this, some surface portions of the semiconductor tend to be oxidized and to form insulating oxide films. For example, in the case of silicon semiconductor devices, silicon oxide tends to be formed adjacent to superconducting electrodes.

### OBJECTS AND SUMMARY OF THE INVENTION

It is therefore an object of the present invention to provide a superconducting device which at least substantially avoids the abovementioned degradation problems originating from oxidation of portions contacting a superconducting ceramic or from any other adverse influence of the superconducting material.

It is another object of the present invention to provide a method of manufacturing superconducting devices which at least substantially avoids adverse influences on the performance of the devices originating from the firing of superconducting ceramics or from other adverse influences of the presence of superconducting material.

According to one aspect, the present invention provides a superconducting device comprising:
a semiconductor substrate;
a semiconductor device formed at least in part within said substrate;
at least one electrode made of a conductive material compatible with said semiconductor substrate during the formation process of said semiconductor device; and
a superconducting lead connected with said electrode.

According to another aspect, the invention provides a method of manufacturing a superconducting device, said method comprising:
forming a superconducting film on a substrate;
forming an electronic device on said substrate, said electronic device and said superconducting film being spaced apart from each other; and
forming a conductive film in order to connect a terminal of said electronic device to said superconducting device.

Yet another aspect of the invention provides a method of manufacturing a field effect transistor, said method comprising:
forming an insulating film on the surface of a semiconductor substrate;
forming a superconducting film on said insulating film;
partially removing said insulating film and said superconducting film in order to leave superconducting leads;
forming source and drain regions within a portion of the surface of said semiconductor substrate that is free from said superconducting film; and
providing source and drain contacts connecting said source and drain regions with said superconducting leads.

A further aspect of the invention provides a superconducting circuit comprising:
a substrate having a non-conductive surface; a superconducting pattern formed on said nonconductive surface;
an electronic device mounted on said substrate and electrically connected with the superconducting pattern; and
wherein said superconducting pattern is formed as a composite film comprising a superconducting film and a metallic film, and said device is connected only with the metallic film part of said superconducting film.

These and other aspects of the invention which are set forth with particularity in the appended subordinate claims will become clear to those possessed of the appropriate skills from consideration of the following description of exemplary embodiments which are illustrated in the accompanying drawings.

### BRIEF DESCRIPTION OF THE DRAWINGS

Figs.1(A) to 1(D) are cross-sectional views showing the method of manufacturing an exemplary superconducting device in accordance with the present invention;

Figs.2(A) to 2(C) are cross-sectional views showing modifications of the superconducting device in accordance with the present invention; and

Figs.3(A) to 3(D) are cross-sectional views showing another method of manufacturing a superconducting device in accordance with the present invention.

## DETAILED DESCRIPTION OF THE PREFERRED EMBODIMENTS

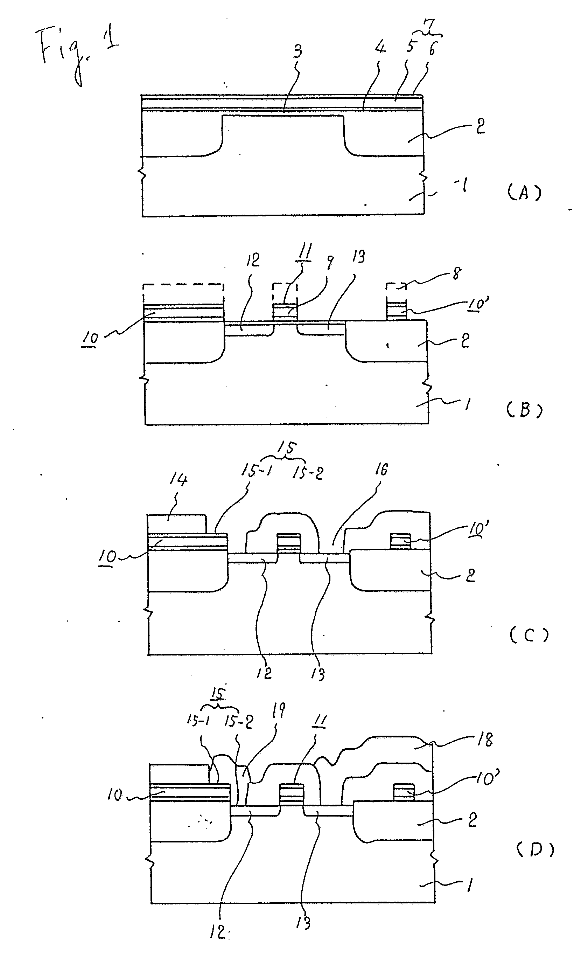

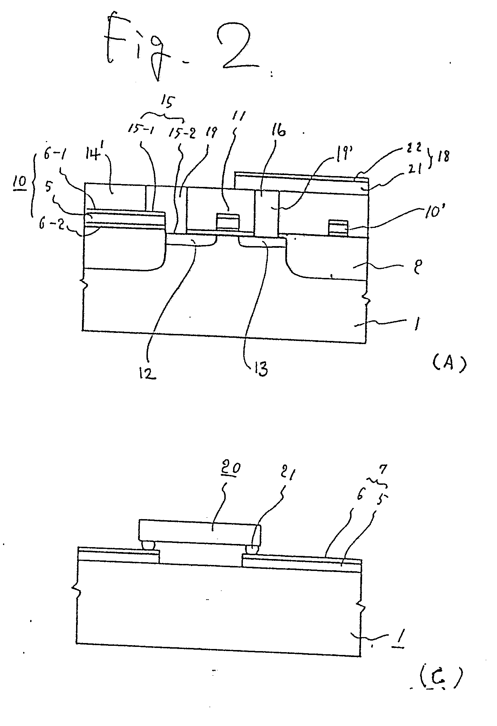

Referring to Figs.1(A) to 1(D), the manufacturing process of an exemplary insulated gate field effect transistor in accordance with the present invention is illustrated.

The upper portion of a silicon semiconductor substrate 1 is selectively oxidized to form a field insulating film 2. The upper surface of this structure is oxidized at a high temperature to form a silicon oxide film 3 of 200Å thickness. A very thin upper portion of the silicon oxide film 3 is provided with a 5-20Å thick blocking film 4 of silicon nitride by a solid-vapor phase reaction between silicon and ammonia.

Then, a superconducting ceramic film 5 is deposited to a thickness of 0.2 to 2 microns, e.g. 0.5 micron, on the structure at a substrate temperature of 700°C by sputtering in an argon oxygen atmosphere. The input power is 100W at 50Hz. The target composition is $YBa_2Cu_{3.6}O_{6-8}$. By use of this target, the composition of the deposited superconducting ceramic conforms to $YBa_2Cu_3O_{6-8}$. The critical temperature of the superconducting ceramic is about 84°K.

Next, a metallic film 6 is deposited to a thickness of 100-10000Å on the superconducting ceramic film 5 by sputtering of Cu, Ag or Al. A $TiSi_2$ film of 0.1 to 0.5 micron thickness may additionally be deposited on top of the film 6 if desired. Alternatively, the conductive film 6 may be formed from a silicon material doped with phosphorous or boron, from a non-oxidizing heat-resistant metal such as tungsten, or from a metal semiconductor such as $WSi_2$. Whatever option is used, this embodiment requires the conductive film 6 to be heat-resistant.

By use of photolithography and with a photoresist mask 8 formed on the structure, a portion of the laminate consisting of the films 4, 5 and 6 is removed by etching, for example by plasma etching. The etchant may be an acid such a sulphuric acid or hydrochloric acid. The photoresist 8 is removed after the etching is completed.

Next, as illustrated in Fig.1(B), a source region 12 and a drain region 13 are formed within the silicon semiconductor substrate 1 by ion implantation followed by thermal annealing at 950°C. After cooling, the structure is subjected to supplemental annealing at 500-600°C for 1-2 hours. The supplemental annealing allows the superconducting ceramic material to form a modulated perovskite-like structure and, as a result, a high critical temperature is realized. The superconducting ceramic areas thus obtained on the substrate constitute multilayered superconducting leads 10 and 10' for interconnecting devices and contacts formed in or on the semiconductor substrate and also constitute a gate electrode 11 made of the multilayered superconductor.

An insulating film 14 of 0.3-1.0 micron thickness is then formed over the entire upper surface of the structure, and then is selectively removed by use of a known photoetching technique in order to provide openings 15 and 16 as shown in Fig.1(C). A portion of the superconducting film 5 of the lead 10 is exposed through the opening 15 at 15-1 while a portion of the source region 12 formed within the substrate is also exposed through the opening 15 at 15-2. A portion of the drain region 13 is also exposed through the opening 16.

As shown in Fig.1(D), an aluminium film of 0.3 to 1.0 micron thickness and a non-reactive metallic film of 0.05 to 0.2 micron thickness are formed over the structure and selectively etched to form contacts 19 and 18 on the source region 12 and the drain region 13 respectively. The contacts 18 and 19 may be made to have zero resistance by coating them with a superconducting ceramic film. The material forming the contacts 18 and 19 has to be compatible with the semiconductor, and examples of suitable materials are $WSi_2$, $MoSi_2$ or Si. Metals are not generally suitable since semiconductors tend to absorb them.

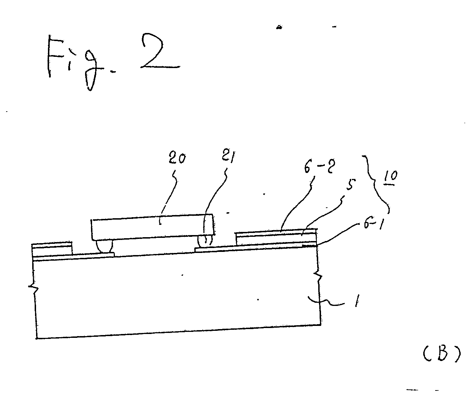

Fig.2(A) shows a second embodiment of the present invention which is a modification of the foregoing embodiment, and corresponding parts of the second embodiment are given similar reference numerals to those used in the first embodiment. The leads 10 and 10' and the gate electrode 11 are composed of a superconducting ceramic film 5 sandwiched between a lower metallic film 6-1 and an upper metallic film 6-2, both metallic films being compatible with the superconducting film 5. An electrode 19 is formed within an opening 15 formed in an insulating film 14' in order to electrically connect the surface 15-1 of the upper metallic film 6-1 with the upper surface 15-2 of the semiconductor. Also, an electrode 19' is formed to contact the surface of the drain region 13 through an opening 16 formed in the insulating film 14'. The electrodes 19 and 19' are made of tungsten by a selective growth method. The upper portion of the electrode 19' is electrically connected to a lead 18 composed of a superconducting ceramic film 18-2 and a metallic film 18-1.

An application of such a composite superconducting lead 10 is illustrated in Fig.2(B). A composite electrode composed of a metallic film 6-1, a superconducting ceramic film 5 and a Cu or Ag film 6-2 is formed on the surface of a heat-resistant substrate 1. The substrate 1 is made from chosen materials whose thermal expansion coefficients are approximately equal to that of the superconducting material, such as alumina, YSZ (yttrium stabilized zircon) or strontium titanate for example. The lower conductive film 6-1 extends inwardly beyond the superconducting ceramic film 5 and the film 6-2 to form contacts on which an IC chip is mounted through bumps 21 in accordance with the face down or flip-chip method. The IC chip could also be mounted on the upper conductive film of the composite electrodes as shown in Fig.2(C).

The substrate employed in the examples shown in Figs.2(B) and 2(C) may be a ceramic substrate, a plastics substrate, a printed circuit board or the like. The superconducting electrode patterns can be manufactured by depositing a superconducting ceramic film, forming a metallic film thereon, and selectively removing the metallic film and the superconducting film by masking and etching using an acid. On the surface having these superconducting patterns, IC chips, transistor chips and other elements (SMC) in the form of microchips may be mounted and connected by wire bonding.

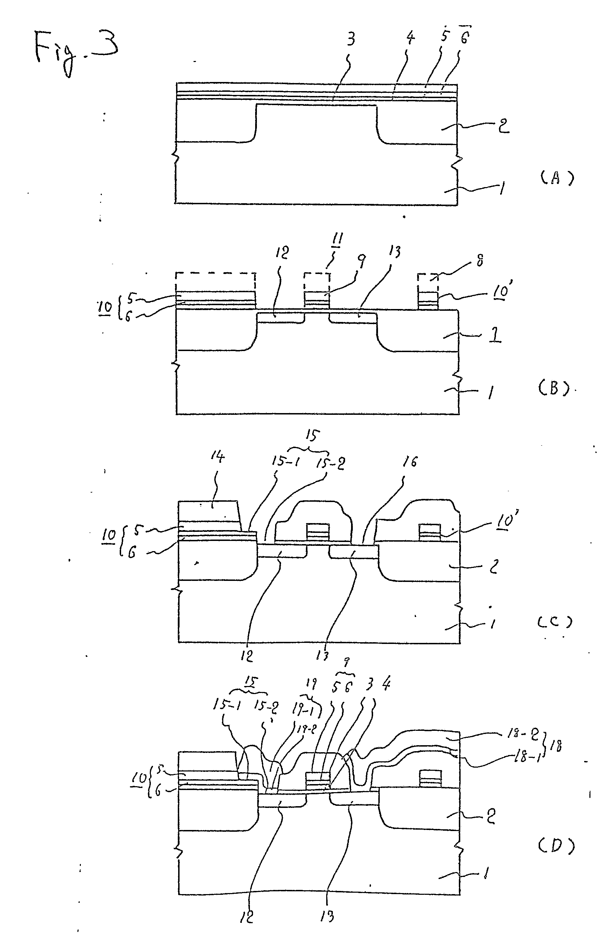

Figs.3(A) to 3(D) are cross-sectional views showing another manufacturing method in accordance with the present invention. This embodiment is substantially the same as the first embodiment, and therefore like numerals are given to like parts and redundant explanation will be dispensed with.

After forming a blocking film of 5-20Å thickness in the same manner as the first embodiment, a superconducting ceramic film 5 is deposited followed by annealing. Then, a conductive film 6 is formed thereon.

The source and drain electrodes are composed of normal conducting films 19-1 and 18-1 and superconducting films 19-2 and 18-2. The normal conducting film is a composite film composed of an aluminium film of 0.1-0.3 micron thickness and a silver film of 0.05-0.2 micron thickness formed thereon.

Other elements of this embodiment are the same as the first embodiment, although not described.

Superconducting ceramics for use in the practice of the present invention may also be prepared to be consistent with the stoichiometric formulae $(A_{1x}B_x)_yCu_2O_w$, where A is one or more elements of Group IIIa of the Japanese Periodic Table, e.g. the rare earth elements, B is one or more elements of Group IIa of the Japanese Periodic Table, e.g. the alkaline earth metals including beryllium and magnesium, and $0 < x < 1$; $y = 2.0-4.0$, preferably 2.5-3.5; $z = 1.0-4.0$, preferably 1.5-3.5; and $w = 4.0-10.0$, preferably 6.0-8.0. Also, superconducting ceramics for use in accordance with the present invention may be prepared to be consistent with the stoichiometric formulae $(A_{1x}B_x)_yCu_2O_w$, where A is one or more elements of Group Vb of the Japanese Periodic Table such as Bi, Sb and As, B is one or more elements of Group IIa of the Japanese Periodic Table, e.g. the alkaline earth metals including beryllium and magnesium, and $0.3 \leqq x < 1$; $y = 2.0-4.0$, preferably 2.5-3/5; $z = 1.0-4.0$, preferably 1.5-3.5; and $w = 4.0-10.0$, preferably 6.0-8.0. Examples of this general formula are $BiSrCaCuCu_2O_x$ and $Bi_4Sr_3Ca_3Cu_4O_x$. The Tc onset and Tco temperatures of samples confirmed to be consistent with the formula $Bi_4Sr_yCa_3Cu_4O_x$ (y being around 1.5) were measured to be 40-60°K, which is not particularly high. Relatively high critical temperatures were obtained with samples conforming to the stoichiometric formulae $Bi_4Sr_4Ca_2Cu_4O_x$ and $Bi_2Sr_3Ca_2Cu_2O_x$ where the number x denoting the oxygen proportion is 6-10, e.g. around 8.1. Such superconducting materials can be formed by screen press printing, vacuum evaporation or CVD.

Also, organic superconducting materials which has received a great deal of attention can be used for embodying the present invention.

While several exemplary embodiments have been described herein, it is to be understood that the present invention is limited only by the appended claims and is not limited to the particular examples described, For example, the present invention can be applied for VLSIs or USLIs.

## Claims

1. A superconducting device comprising:
a semiconductor substrate;
a semiconductor device formed at least in part within said substrate;
at least one electrode made of a conductive material compatible with said semiconductor substrate during the formation process of said semiconductor device; and
a superconducting lead connected with said electrode.

2. The superconducting device of claim 1 wherein said semiconductor device is an insulated gate field effect transistor.

3. The superconducting device of claim 2 wherein the insulated gate is formed as a portion of superconducting lead.

4. The superconducting device of claim 3 wherein said superconducting lead portion is formed on a field insulating film.

5. The superconducting device of any preceding claim wherein said superconducting lead is a laminate composed of a metallic film and a superconducting film.

6. A method of manufacturing a superconducting device, said method comprising:
forming a superconducting film on a substrate;
forming an electronic device on said substrate, said electronic device and said superconducting film being spaced apart from each other; and
forming a conductive film in order to connect a terminal of said electronic device to said superconducting device.

7. A method of manufacturing a field effect transistor, said method comprising:
forming an insulating film on the surface of a semiconductor substrate;
forming a superconducting film on said insulating film;
partially removing said insulating film and said superconducting film in order to leave superconducting leads;
forming source and drain regions within a portion of the surface of said semiconductor substrate that is free from said superconducting film; and
providing source and drain contacts connecting said source and drain regions with said superconducting leads.

8. The method of claim 7 wherein said removing step is performed to form a gate electrode comprising a portion of said superconducting film.

9. The method of claim 7 or 8 wherein said superconducting film is a composite film composed of a lower metallic conductive film and a superconducting ceramic film.

10. A superconducting circuit comprising:

a substrate having a non-conductive surface;
a superconducting pattern formed on said nonconductive surface;
an electronic device mounted on said substrate and electrically connected with the superconducting pattern; and

wherein said superconducting pattern is formed as a composite film comprising a superconducting film and a metallic film, and said device is connected only with the metallic film part of said superconducting film.

Fig. 1

(A)

(B)

(C)

(D)

Fig. 2

(A)

(C)

Fig. 2

(B)

EP 0 303 521 A2

Fig. 3